(19) Europäisches Patentamt
European Patent Office
Office européen des brevets

(11) **EP 2 937 902 B1**

(12) **FASCICULE DE BREVET EUROPEEN**

(45) Date de publication et mention
de la délivrance du brevet:
**09.01.2019 Bulletin 2019/02**

(51) Int Cl.:
*H01L 27/144* (2006.01)   *H01L 31/0296* (2006.01)
*H01L 31/0352* (2006.01)   *H01L 31/103* (2006.01)
*H01L 31/18* (2006.01)

(21) Numéro de dépôt: **15164172.7**

(22) Date de dépôt: **20.04.2015**

(54) **MATRICE DE PHOTODIODES EN CDHGTE**

MATRIX AUS CDHGTE-FOTODIODEN

CDHGTE PHOTODIODE ARRAY

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **22.04.2014 FR 1400950**

(43) Date de publication de la demande:
**28.10.2015 Bulletin 2015/44**

(73) Titulaire: **Commissariat à l'Énergie Atomique
et aux Énergies Alternatives
75015 Paris (FR)**

(72) Inventeurs:
• **Mollard, Laurent
38640 CLAIX (FR)**
• **Bourgeois, Guillaume
38000 GRENOBLE (FR)**
• **Destefanis, Gérard
38120 SAINT-EGREVE (FR)**

(74) Mandataire: **Brevalex
56, Boulevard de l'Embouchure
B.P. 27519
31075 Toulouse Cedex 2 (FR)**

(56) Documents cités:
**EP-A1- 0 445 545     FR-A1- 2 983 351
JP-A- S62 119 976     US-A- 4 588 446
US-A- 4 961 098       US-A- 5 880 510**

EP 2 937 902 B1

## Description

## DOMAINE TECHNIQUE

La présente invention concerne le domaine des photodiodes infrarouges en CdHgTe, utilisées pour détecter un rayonnement infrarouge.

## ÉTAT DE LA TECHNIQUE ANTÉRIEURE

On connaît dans l'art antérieur différentes sortes de matrices de photodiodes, en particulier les matrices de photodiodes réalisées dans une couche en matériau semi-conducteur fait d'un alliage de cadmium, mercure et tellure $Cd_xHg_{1-x}Te$, avec x un réel compris entre 0 et 1, les bornes étant exclues. Dans tout le texte, toute cette couche en matériau semi-conducteur est nommée « couche utile ». Dans tout le texte, la couche utile désigne toute la couche en matériau semi-conducteur, incluant la région d'absorption des photons présentant un premier type de dopage N ou P, les jonctions PN, et les zones dites dopées présentant un deuxième type de dopage P ou N.

Ces matrices de photodiodes sont utilisées par exemple dans le domaine spatial, pour la détection du rayonnement infrarouge, notamment l'infrarouge moyen (ou MWIR pour l'anglais « Middle Wave InfraRed », correspondant à des longueurs d'onde comprises entre 4 $\mu m$ et 5 $\mu m$ à 80 K) et l'infrarouge lointain (ou LWIR pour l'anglais « Long Wave InfraRed » correspondant à des longueurs d'onde supérieures à 8 $\mu m$ à 80 K).

On peut également les utiliser pour la détection du SWIR « Small Wave Infrared » correspondant à des longueurs d'onde entre 2 et 3 $\mu m$ à 80 K, et du VLWIR « Very Long Wave Infrared » correspondant à des longueurs d'ondes supérieures à 12 $\mu m$ à 80 K.

On réalise par exemple des matrices rectangulaires regroupant 640x512 photodiodes, pour un pas 15 $\mu m$ (largeur d'une photodiode).

On connaît par exemple une matrice mésa telle que décrite dans le brevet US 5,880,510, présentant une couche de passivation formée par diffusion de cadmium. La diffusion du cadmium se fait sur une faible épaisseur de la matrice mésa, partout excepté au niveau de futurs plots de connexion électrique.

On connaît également le document US 4,588,446, qui enseigne comment réaliser un gradient de cadmium à l'aide d'un recuit.

Le document EP 0 445 545 s'intéresse à des matrices dans lesquelles les photodiodes sont séparées par des sillons, et les porteurs de charge sont confinés entre les sillons grâce à une concentration en cadmium plus élevée en profondeur.

Le document US 4,961,098 s'intéresse également à des matrices dans lesquelles les photodiodes sont séparées par des sillons, pour empêcher la diffusion latérale des porteurs de charge.

Le document FR 2 983 351 décrit une matrice de photodiodes dans laquelle des régions dopées P+ coïncident avec des caissons riches en de cadmium.

On peut également citer le document JP 62 119976, qui s'intéresse à la passivation des surfaces du substrat, entre les zones dopées.

La qualité d'une matrice de photodiodes peut être quantifiée par différents indicateurs.

L'un de ces indicateurs est par exemple sa fonction de transfert de modulation (FTM). Elle est généralement représentée par un graphique représentant un rapport entre un contraste mesuré et un contraste théorique, en fonction d'une fréquence (ici l'inverse du pas de la matrice de photodiodes). La FTM illustre la capacité de la matrice de photodiodes à transcrire fidèlement une répartition de photons incidents, sous la forme d'une carte de courants mesurés sur les photodiodes. Il est donc avantageux qu'une matrice de photodiodes présente une bonne FTM, afin qu'elle offre une image qui retranscrit fidèlement la réalité.

Un autre indicateur est son courant dit courant d'obscurité. Le courant d'obscurité est le courant électrique résiduel d'un photodétecteur en l'absence d'éclairement lumineux.

Un objectif de la présente invention est de proposer une matrice de photodiodes $Cd_xHg_{1-x}Te$ présentant une qualité améliorée à l'égard d'au moins un des indicateurs communément utilisés pour quantifier cette qualité.

Un autre but de la présente invention est de proposer un procédé de fabrication d'une telle matrice de photodiodes.

## EXPOSÉ DE L'INVENTION

Cet objectif est atteint avec une matrice de photodiodes selon la revendication 1 ou la revendication 3.

Avantageusement, la concentration moyenne en cadmium dans ladite région est supérieure à la concentration moyenne en cadmium dans le reste de la couche utile.

La première zone dopée est avantageusement dopée P par des atomes d'arsenic.

L'invention concerne également un procédé de fabrication d'une matrice de photodiodes selon la revendication 6.

La réalisation d'une couche structurée peut mettre en oeuvre :

- un dépôt d'une couche de réservoir sur la face supérieure de la couche utile ; et
- une gravure d'au moins une ouverture traversante dans la couche de réservoir, la gravure étant une gravure chimique.

Les étapes de réalisation d'une couche structurée et recuit, forment avantageusement un cycle de fabrication, et on met en oeuvre au moins deux cycles de fabrication.

L'étape de réalisation de jonctions PN peut mettre en oeuvre une implantation ionique d'arsenic.

De préférence, le recuit est réalisé à une température comprise entre 100°C et 500°C.

Le recuit est avantageusement réalisé pendant une durée comprise entre 1h et 100h.

## BRÈVE DESCRIPTION DES DESSINS

La présente invention sera mieux comprise à la lecture de la description d'exemples de réalisation donnés à titre purement indicatif et nullement limitatif, en faisant référence aux dessins annexés sur lesquels :

- la figure 1 illustre de manière schématique un premier example de procédé;
- la figure 2 illustre de manière schématique un deuxième exemple de procédé;
- la figure 3 illustre de manière schématique un premier mode de réalisation de matrice de photodiodes selon l'invention ;
- la figure 4 illustre de manière schématique un deuxième exemple de matrice de photodiodes; et
- la figure 5 illustre de manière schématique un troisième mode de réalisation de matrice de photodiodes selon l'invention.

## EXPOSÉ DÉTAILLÉ DE MODES DE RÉALISATION PARTICULIERS

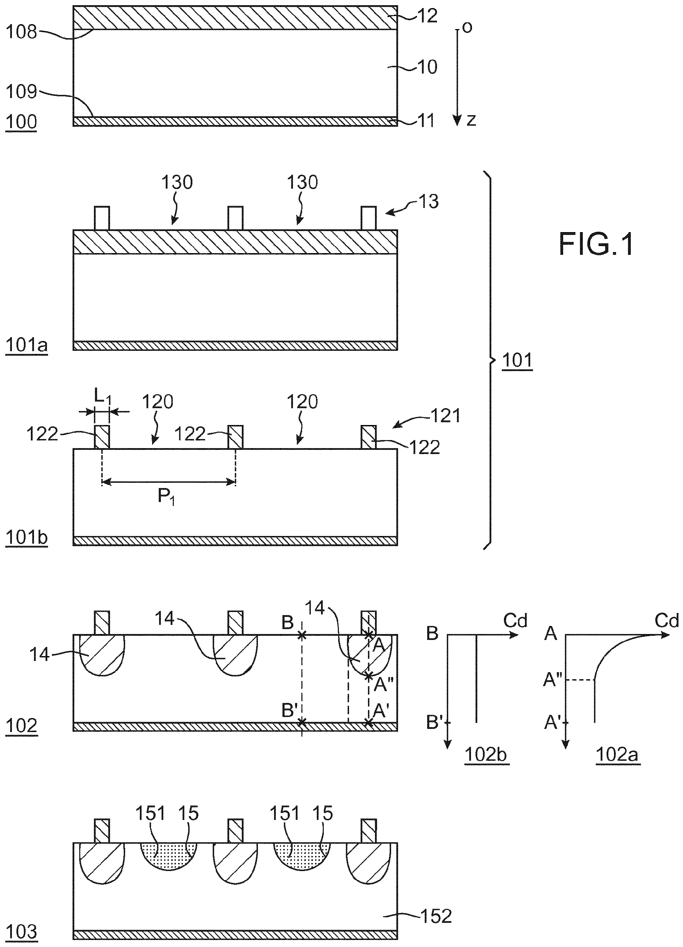

Pour des raisons de clarté, on illustrera tout d'abord un procédé de fabrication d'une matrice de photodiodes. On a illustré, en figure 1, et de façon schématique, les étapes d'un tel procédé.

On dispose initialement d'une couche utile 10 en matériau semi-conducteur fait d'un alliage de cadmium, mercure et tellure $Cd_xHg_{1-x}Te$, avec x un réel compris entre 0 et 1, les bornes étant exclues. On a typiquement x compris entre 0,2 et 0,4 par exemple x=0,22. Dans cet exemple, la composition de la couche utile 10 est initialement constante dans l'espace.

Par exemple, on cherchera à détecter un rayonnement dans l'infrarouge moyen dit MWIR, ce qui correspond à une concentration en cadmium x=0,3. En variante, on cherche à détecter un rayonnement dans l'infrarouge lointain dit LWIR, ce qui correspond à une concentration en cadmium définie par x=0,22.

Cette couche utile 10 est réalisée ici sur un substrat 11, par exemple un substrat fait d'un alliage de cadmium, zinc, tellure. Un tel alliage offre un accord de maille très avantageux du matériau de la couche utile 10 avec le substrat 11. Le substrat 11 est avantageusement transparent aux longueurs d'onde que l'on souhaite détecter. Selon une variante non représentée, le substrat est séparé de la couche utile avant, pendant ou après la mise en oeuvre du procédé.

La couche utile 10 présente typiquement une épaisseur comprise entre 0,1 $\mu$m et 20 $\mu$m, par exemple 15 $\mu$m. Le substrat 11 présente une épaisseur de l'ordre de 500 $\mu$m. Pour des raisons de clarté des figures, l'épaisseur du substrat 11 est sous-dimensionnée sur les figures.

La couche utile est avantageusement réalisée sur le substrat 11 par une technique dite d'épitaxie en phase liquide. L'épitaxie en phase liquide est une technique de croissance d'un cristal dans laquelle le substrat 11 est mis en contact avec une phase liquide d'un élément souhaité (ici $Cd_xHg_{1-x}Te$) qui se cristallise sur le substrat. En variante, la couche utile peut être réalisée sur le substrat 11 par une technique dite d'épitaxie par jet moléculaire. L'épitaxie par jet moléculaire est une technique de croissance d'un cristal dans laquelle les éléments à déposer sur le substrat 11 sont évaporés puis vont se déposer sur le substrat. On pourra également envisager toute autre technique de dépôt d'une couche cristalline sur un substrat, par exemple un dépôt chimique en phase vapeur.

La couche utile présente par exemple une forme de parallélépipède, notamment un parallélépipède rectangle. On définit dans cette couche utile un axe z définissant l'axe de la profondeur, partant de la face supérieure 108, et reliant les faces 108 et 109. La face 109 est une face inférieure, au contact du substrat 11. La face 108 est une face supérieure du côté opposé à la face inférieure 109.

Etape 100 :

Lors de l'étape 100, on dépose sur la face supérieure 108 de la couche utile 10 une couche dite couche de réservoir 12 dont un des éléments est du cadmium et présentant une concentration en cadmium supérieure à la concentration en cadmium de la couche utile 10.

La couche de réservoir 12 présente une épaisseur de l'ordre du micromètre, par exemple entre 0,1 $\mu$m et 2 $\mu$m, en particulier 1 $\mu$m.

Le dépôt de la couche de réservoir 12 est effectué par toute technique connue de dépôt de couche mince. La couche de réservoir est réalisée en un matériau binaire, ternaire, quaternaire voire plus, à partir notamment des éléments des colonnes II et VI : par exemple et de manière non limitative CdS, CdSe, CdTe, CdZnSe, CdMnSSe...

La couche de réservoir 12 forme ainsi une couche uniforme qui recouvre toute la face supérieure 108 de la couche utile 10.

Etape 101 :

La couche de réservoir 12 est ensuite gravée de façon à y former des ouvertures traversantes 120. On nomme cette étape structuration, ou texturation de la couche de réservoir 12. La couche de réservoir après structuration forme une couche dite structurée 121. La couche structurée 121 présente donc la même concentration en cadmium que la couche de réservoir.

Dans l'exemple représenté en figure 1, la couche structurée 121 consiste en des plots 122 ou des lignes, présentant par exemple une largeur $L_1$ de 1 $\mu$m, et répartis selon un maillage carré présentant un pas $P_1$ de 15 $\mu$m.

La couche structurée peut dessiner un maillage présentant tout type de forme élémentaire, par exemple un rond, un carré, ou toute autre forme. Par abus de langage, on peut dire que chaque forme est destinée à entourer une photodiode (voir plus loin). Chaque forme destinée à entourer une photodiode peut être continue ou discontinue (par exemple rond continu ou en pointillés). La couche structurée peut également être telle que seulement certaines photodiodes seront entourées par une forme élémentaire.

Cette couche structurée peut également être de largeur variable d'un endroit à l'autre le long d'une forme destinée à entourer une photodiode, par exemple passant d'une largeur de 2 $\mu$m à 4 $\mu$m.

En fonction des caractéristiques souhaitées de la structure, l'homme du métier saura adapter les conditions de dépôt et de gravure.

L'étape 101 se décompose par exemple en deux étapes 101a et 101b.

Etape 101a :

Dans une première étape 101a, on dépose une couche de résine sur la couche de réservoir 12, puis on grave dans cette résine des ouvertures traversantes 130. Il s'agit préférentiellement d'une gravure par photolithographie. On forme ainsi un masque de résine 13, situé sur la couche de réservoir 12.

Etape 101b :

Dans une deuxième étape 101b, on grave la couche de réservoir 12 à travers le masque de résine 13. Ainsi, on grave la couche de réservoir 12 uniquement aux emplacements non recouverts par la résine.

La gravure est avantageusement une gravure chimique, typiquement une gravure chimique à l'aide d'une solution de Brome (solution de dibrome $Br_2$).

On ajuste la profondeur de gravure en ajustant une durée de la gravure chimique. En pratique, la couche de réservoir peut présenter un aspect différent de la couche utile, c'est pourquoi on pourra repérer optiquement le moment à compter duquel on peut faire cesser la gravure chimique.

D'autres méthodes de structuration du réservoir de cadmium sont également envisageables telles qu'une gravure chimique sélective s'arrêtant sur la couche utile ou une gravure sèche de type ionique ou plasma. Toute autre technique de structuration du réservoir est également envisageable.

Les étapes suivantes :

- dépôt 100, sur la face supérieure 108 de la couche utile, d'une couche de réservoir 12 présentant une concentration en cadmium supérieure à la concentration moyenne en cadmium de la couche utile 10 ; et

- gravure 101 d'au moins une ouverture traversante 120 dans la couche de réservoir, formant ainsi une couche dite structurée 121 ;

forment ensemble une étape de réalisation, sur ladite face supérieure 108, d'une couche structurée 121 présentant au moins une ouverture traversante 120, et une concentration en cadmium supérieure à la concentration moyenne en cadmium dans la couche utile 10.

Il est également envisageable de réaliser la couche structurée 121 par une technologie « lift-off ». Il s'agit par exemple de déposer une couche structurée de résine sur la face supérieure 108, et de recouvrir le tout par la couche de réservoir 12. La couche de réservoir se dépose donc sur la résine, là où la résine est présente, et sur la couche utile 10 au niveau des ouvertures traversantes dans la résine. En retirant la résine, on obtient la couche structurée 121.

Etape 102 :

On effectue ensuite un recuit de l'ensemble formé par la couche utile 10 et la couche structurée 121. Ce recuit sera par exemple effectué à une température comprise entre 100°C et 500°C, de préférence entre 300°C et 500°C, et pendant une durée pouvant aller de quelques minutes à plusieurs heures, par exemple entre 1h et 40h. Dans l'exemple représenté en figure 1, le recuit correspond à un chauffage à 430° durant 50 h.

Pour l'ensemble des recuits nécessaires, l'homme du métier saura procéder à des recuits dans des conditions de pression et température qui limitent la dégradation du matériau.

Au cours de ce recuit, les atomes de cadmium de la couche structurée 121 vont diffuser vers la couche utile 10. On peut donc parler d'un recuit de diffusion.

Il se forme ainsi dans la couche utile des régions 14 présentant chacune un gradient de concentration en cadmium décroissant, depuis la face supérieure 108 vers la face inférieure 109 de la couche utile.

Les graphiques 102a et 102b représentent une concentration en cadmium Cd dans la couche utile (axe des abscisses) en fonction de la profondeur dans la couche utile (axe des ordonnées).

Le graphique 102b correspond à une coupe dans la couche utile selon l'axe BB' ne passant pas dans une région 14 telle que décrite ci-dessus. On voit bien que la concentration en cadmium présente alors une valeur constante, et correspondante à la concentration initiale en cadmium de la couche utile.

Le graphique 102a correspond à une coupe dans la couche utile selon l'axe AA' passant dans une région 14 telle que décrite ci-dessus. La concentration en cadmium présente un profil décroissant progressivement à partir de la face supérieure 108 et en direction de la face inférieure 109. Par exemple, ce gradient prend une valeur maximale définie par x=0,5 dans du $Cd_xHg_{1-x}Te$, et une valeur minimale définie par x=0,22 et correspondant à la concentration initiale en cadmium de la couche utile. Le gradient, et donc la région 14, s'étend dans la couche utile jusqu'en A". Dans tout le texte, une concentration constante de cadmium ne définit pas un gradient de concentration.

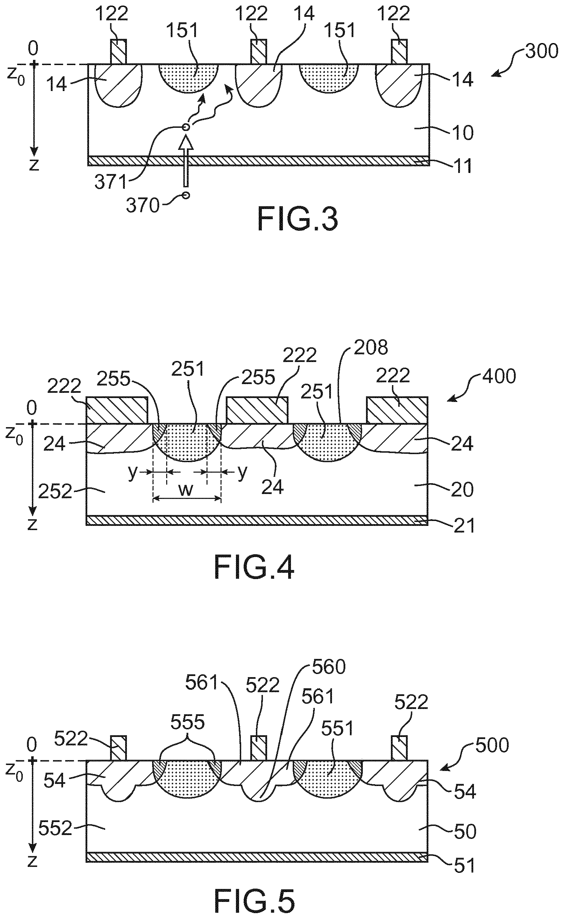

On peut considérer des surfaces dans la couche utile, parallèles à la face supérieure 108, et définie par une profondeur z dans la couche utile. Passé une profondeur prédéterminée $z=z_0$ (voir figure 3) dans la couche utile 10, l'intersection d'une telle surface avec les régions 14 présente une concentration moyenne en cadmium supérieure à la concentration moyenne en cadmium de l'intersection de cette même surface avec le reste de la couche utile.

On a en particulier, $z_0=0$. En d'autres termes, la concentration moyenne en cadmium dans les régions 14 est supérieure à la concentration moyenne en cadmium dans le reste de la couche utile, notamment dans une région destinée à former une région d'absorption de la couche utile, dans laquelle les photons à la longueur d'onde que l'on souhaite détecter vont former des porteurs minoritaires.

On peut nommer les régions 14 « hétéro-structure 3D». Les régions 14 débouchent toute sur la face supérieure 108.

En fonction des caractéristiques souhaitées du profil du gradient de concentration en cadmium dans les régions 14, l'homme du métier saura adapter la température et la durée du recuit.

La diffusion des atomes, notamment des atomes de cadmium, peut être approximée par une loi de diffusion standard de type Fick :

$$n(z, t) = \frac{1}{\sqrt{\pi D t}}\, e^{-\frac{z^2}{4Dt}},$$

avec

- n(z, t) la concentration volumique en atomes d'une espèce donnée en fonction de la profondeur z et du temps t ;
- t la durée du recuit ;
- D le coefficient de diffusion de l'atome, avec $D = D_0\, e^{-\frac{Ea}{kT}}$, T la température du recuit et Ea l'énergie d'activation de la diffusion (quantité d'énergie nécessaire pour lancer le processus de diffusion des atomes).

On voit sur le graphique 102a que le gradient de concentration en cadmium suit bien une courbe décroissante en partant de la face supérieure 108 (point A) et en direction de la face inférieure 109 (jusqu'au point A"), selon une décroissance sensiblement exponentielle.

Etape 103 :

Au cours de l'étape 103, on réalise au moins deux jonctions PN 15 dans la couche utile. Chaque jonction PN forme une photodiode.

Les jonctions PN sont réalisées entre les régions 14, par exemple par implantation ionique entre des plots 122.

A chaque photodiode correspond une première zone dopée 151. Chaque jonction PN sépare une première zone dopée 151, d'une deuxième zone dopée 152 commune à chacune des photodiodes. La deuxième zone dopée 152 entoure les premières zones dopées 151, et présente un dopage de type différent (N ou P). Chaque jonction PN forme une surface convexe dans la couche utile, entre l'une des premières zones dopées 151 et la deuxième zone dopée 152.

Les jonctions PN affleurent sur la face supérieure 108 de la couche utile.

On pourra envisager de réaliser une jonction PN selon l'une des nombreuses techniques connues dans l'art antérieur.

De façon avantageuse, on réalise une zone dopée P (excès de « trous », ou en d'autres termes défaut d'électrons) au sein d'un matériau dopé N (excès d'électrons). Pour cela, on implante un élément dopant P dans la couche utile, préférentiellement de l'arsenic. On réalise ensuite un recuit à environ 400°C pour activer le dopant P. Ce recuit crée des lacunes de mercure dans toute la couche utile 10. On obtient donc une zone fortement dopée P (grâce à l'implantation d'arsenic) et une zone faiblement dopée P (à cause des lacunes de mercure). On réalise ensuite un recuit à environ 220°C sous pression saturante de mercure pour combler les lacunes de mercure. La zone faiblement dopée P devient dopée N. La zone fortement dopée P est référencée 151 et correspond à une première zone dopée selon l'invention. La zone dopée N est référencée 152 et correspond à la deuxième zone dopée.

La densité de dopage dans la deuxième zone dopée 152 est alors de l'ordre de $1.10^{16}$ atomes/cm³. La densité de dopage dans les premières zones dopées 151 est de l'ordre de $10^{18}$ atomes/cm³.

En variante, on pourra réaliser une zone fortement dopée N (première zone dopée 151) dans un matériau dopé P (deuxième zone dopée 152). Pour cela, on réalise un recuit pour ajuster le niveau de lacunes de mercure, de façon à doper P le reste de la couche utile puis on implante un élément dopant N dans la couche utile, préférentiellement du bore.

Ces deux premiers exemples de réalisation d'une jonction PN correspondent à une implantation ionique. On obtient ainsi une photodiode présentant une structure planaire, sans étape de gravure pouvant impacter le courant d'obscurité.

En variante, on pourra réaliser une photodiode à avalanche dans la couche utile. On réalise tout d'abord un recuit pour ajuster le niveau de lacunes de mercure, de façon à doper P la couche utile puis on crée, par un procédé technologique adéquat, une zone dopée N

Tout autre type de diode pourrait être réalisé.

L'étape 103 de réalisation de jonctions PN est avantageusement mise en oeuvre après la réalisation des régions 14. Cependant, on peut également envisager de réaliser les jonctions PN avant réalisation des régions 14, en particulier dans le cas où les premières zones dopées 151 sont dopées P. Le recuit de diffusion des atomes de cadmium peut réaliser également l'activation d'un dopant P.

On pourra ensuite réaliser des étapes classiques d'installation d'au moins un élément de contact électrique au contact de la couche utile. Cet élément de contact électrique permet de polariser électriquement la photodiode.

On peut supprimer la couche correspondant, après recuit, à la couche structurée 121. On utilisera par exemple une gravure chimique telle que décrite en référence à l'étape 101b de la figure 1.

On obtient ainsi une matrice de photodiodes 300 telle que représentée en figure 3.

Les régions 14 présentent un gradient de concentration en cadmium, et s'étendent en profondeur dans la couche utile, plus ou moins profondément que les premières zones dopées 151. Ces régions 14 à gradient de composition peuvent également traverser entièrement la couche utile, c'est-à-dire s'étendre jusqu'à la couche inférieure 109.

Dans l'exemple représenté en figure 3, les régions 14 s'étendent plus profondément dans la couche utile que les premières zones dopées 151. Par exemple, les premières zones dopées 151 s'étendent sur 1 µm de profondeur dans la couche utile 10, et les régions 14 s'étendent sur 3 µm de profondeur dans la couche utile 10. En outre, les régions 14 s'étendent à l'extérieur des premières zones dopées 151. Ces deux caractéristiques sont obtenues grâce à l'utilisation :

- d'un recuit long et à température élevée, permettant la diffusion du cadmium en profondeur dans la couche utile ; et
- d'une couche structurée présentant des plots 122 étroits, ce qui évite que la diffusion des atomes de cadmium dans la couche utile étale les régions 14 et ne permette plus que ces régions restent à l'extérieur des premières zones dopées 151. Un plot est dit étroit par exemple lorsque la largeur des plots est inférieure à la différence entre le pas de pixel et la largeur des premières zones dopées 151 (les premières zones dopées étant supposées de largeur fixe pour une même matrice). En particulier, la largeur des plots peut être au moins 1,2 fois inférieure à la différence entre le pas de pixel et la largeur des premières zones dopées 151, par exemple deux fois inférieure.

On a observé que dans un matériau semi-conducteur en $Cd_xHg_{1-x}Te$, la bande interdite, nommée « gap », dépend de la concentration en cadmium. Plus cette concentration est élevée, plus le gap est élevé.

Du fait de la différence entre une concentration moyenne en cadmium dans une région 14 et dans le reste de la couche utile, chaque région 14 forme une barrière de potentiel en profondeur, entre deux premières zones dopées 151 voisines, ou en d'autres termes entre deux photodiodes voisines.

En fonctionnement, un photon 370 à une longueur d'onde que l'on souhaite détecter pénètre dans la matrice de photodiodes du côté de sa face inférieure, et au regard d'une photodiode donnée. Ce photon entraîne l'apparition d'un porteur minoritaire 371 dans la couche utile 10. Ce porteur minoritaire 371 diffuse dans la couche utile, jusqu'à ce qu'il se recombine avec un porteur de nature différente. Si ledit porteur minoritaire traverse une jonction PN avant de se recombiner, il permet la création d'un courant mesurable.

Le porteur minoritaire présente une longueur de diffusion qui correspond à la distance parcourue avant de se recombiner. Lorsque la longueur de diffusion est élevée, il existe donc un risque que le porteur minoritaire se recombine après traversée de la jonction PN d'une photodiode voisine. Ce risque est d'autant plus élevé que le pas de la matrice de photodiodes est faible au regard de la longueur de diffusion.

Or, selon l'invention, la matrice de photodiodes présente, entre deux photodiodes voisines, une barrière de potentiel pour les porteurs minoritaires. Les porteurs minoritaires sont donc empêchés de passer à travers cette barrière de potentiel, ce qui évite qu'un porteur minoritaire pénètre dans la matrice de photodiodes au regard d'une première photodiode, et traverse la jonction PN d'une photodiode voisine. Ainsi, un porteur minoritaire qui pénètre dans la matrice de photodiodes au regard d'une première photodiode reste enfermé dans un couloir entre plusieurs régions 14, et ne peut donc traverser la jonction PN d'une autre photodiode.

On évite ainsi qu'un photon incident :

- ne provoque pas l'apparition d'un courant dans la photodiode au regard de laquelle il pénètre dans la matrice de photodiodes ; et
- provoque l'apparition d'un courant dans une photodiode autre que celle au regard de laquelle il pénètre dans la matrice de photodiodes.

Ainsi, la matrice de photodiodes 300 selon l'invention présente une FTM améliorée.

Cet aspect de l'invention est particulièrement avantageux lorsque l'on souhaite que la matrice de photodiodes présente un pas inférieur à la longueur de diffusion des porteurs minoritaires. Cet aspect de l'invention est donc particulièrement avantageux dans le cas où la première zone dopée 151 est dopée P, et la deuxième zone dopée 152 est dopée N (technologie dite « P sur N »). En effet, dans cette technologie, les porteurs minoritaires présentent une durée de vie élevée ce qui leur confère de grandes longueurs de diffusion (en comparaison avec la technologie dite « N sur P » correspondant à une zone 151 dopée N et une zone 152 dopée P).

En faisant varier la température et/ou la durée du recuit, on obtient un profil désiré du gradient de gap dans chaque région 14.

On remarque également que les régions 14, puisqu'elles présentent le même dopage que la deuxième zone dopée 152, n'empêchent pas de polariser toutes les photodiodes d'une même matrice à l'aide d'un même point de contact électrique.

L'invention est particulièrement intéressante dans le cadre de régions 14 traversant entièrement la couche utile. Dans ce cas, les diodes sont complètement isolées les unes des autres et la FTM est optimale. Dans cette configuration et afin de limiter l'impact de la diffusion latérale du cadmium lors de la formation des régions 14, la couche utile est avantageusement réduite à une épaisseur de 1 à 2 μm par exemple.

On remarquera également que l'invention permet de réaliser une couche utile offrant une excellente qualité cristalline puisque les gradients de cadmium sont réalisés par un recuit de diffusion qui préserve l'arrangement cristallin du $Cd_xHg_{1-x}Te$. Il ne serait pas possible d'obtenir une même qualité cristalline par des techniques de reprise d'épitaxie localisée.

L'invention est particulièrement intéressante dans le cas d'une couche utile 10 réalisée par épitaxie en phase liquide. En effet, un avantage de cette technique est d'offrir la meilleure qualité cristalline. Il serait contre-productif de privilégier cette technique de croissance de la couche utile, si l'on venait ensuite détériorer fortement la qualité cristalline de la couche utile (soit par des contaminations de l'environnement extérieur, soit en créant un gradient de gap par une technique ne préservant pas la grande qualité cristalline de la couche utile).

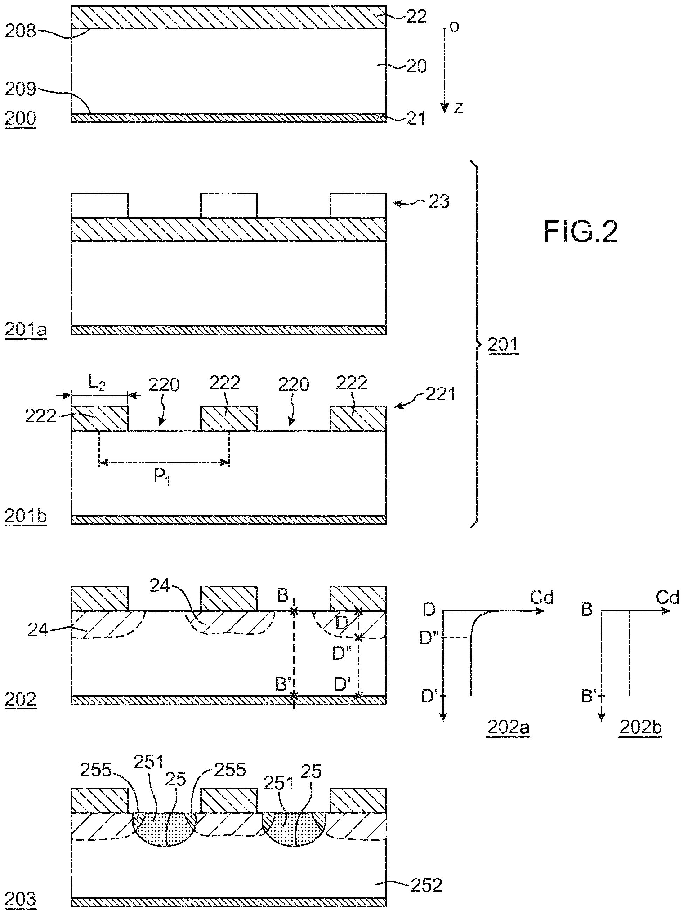

La figure 2 illustre de manière schématique un deuxième exemple de procédé. L'example illustré en figure 2 ne sera décrit que pour ses différences relativement au mode de réalisation représenté en figure 1.

Les références numériques 10, 11, 13, 100, 108, 109, 101, 101a, 101b, 120, 121, 122, 102, 102a, 102b, 14, 15, 151, 152 correspondent respectivement aux références numériques 20, 21, 23, 200, 208, 209, 201, 201a, 201b, 220, 221, 222, 202, 202a, 202b, 24, 25, 251, 252.

A l'étape 201, la couche structurée 221 forme des plots 222 présentant une largeur $L_2$ de 12 μm, et répartis selon un maillage carré présentant un pas $P_1$ de 15 μm.

A l'étape 202, on effectue un recuit correspondant, par exemple, à un chauffage à 430° durant 50h.

Le graphique 202b correspond au graphique 102b de la figure 1. Le graphique 202a correspond à une coupe dans la couche utile selon l'axe DD' passant dans une région 24. Le gradient, et donc la région 24, s'étend dans la couche utile jusqu'en D".

On obtient, grâce au procédé illustré en figure 2, une matrice de photodiodes 400 telle que représentée en figure 4.

Les régions 24 et les premières zones dopées 251 sont ici partiellement superposées. Plus précisément, les régions 24 s'étendent dans un volume périphérique supérieur 255 de chacune des premières zones dopées 251. Par exemple, chaque première zone dopée 251 présente une largeur W de 8 μm (largeur au niveau de la face supérieure 208), et son volume périphérique supérieur 255 présente une largeur y de 2 μm (largeur au niveau de la face supérieure 208). Les régions 24 s'étendent, dans une première zone dopée 251, sur environ un quart du volume de celle-ci.

En outre, les régions 24 s'étendent ici peu profondément dans la couche utile, moins profondément que les premières zones dopées 251. Par exemple, les premières zones dopées 251 s'étendent sur 1 μm de profondeur dans la couche utile 20, et les régions 24 s'étendent sur 0,5 μm de profondeur dans la couche utile 20. Typiquement, les premières zones dopées 251 s'étendent dans la couche utile plus profondément que les régions 24, par exemple 1,5 fois plus profondément. Selon ce mode de réalisation, les performances optimales sont obtenues pour des premières zones dopées 251 traversantes (c'est-à-dire s'étendant jusqu'à la face inférieure 209).

Ces deux caractéristiques sont obtenues grâce à l'utilisation :

- d'un recuit à température moindre (280°C, contre 430°C dans le premier mode de réalisation de procédé selon l'invention), permettant la diffusion du cadmium peu profondément dans la couche utile, et/ou d'un temps de recuit moindre (10h au lieu de 50 h) ; et
- d'une couche structurée présentant des plots 222 relativement larges, ce qui permet que les régions 24 s'étendent jusque dans les premières zones dopées 251. Un plot est dit large par exemple lorsque la largeur des plots est supérieure à la différence entre le pas de pixel et la largeur des premières zones dopées 251 (les premières zones dopées étant supposées de largeur fixe pour une même matrice), par exemple 1,2 fois supérieure à cette différence.

La matrice de photodiodes 400 présente donc un gradient de concentration en cadmium décroissant depuis sa face supérieure 208 vers sa face inférieure 209, et présent uniquement entre les premières zones dopées 251 et sur les bords de celles-ci.

Ainsi les bords des premières zones dopées 251 sont positionnés dans un matériau plus grand gap permettant de réduire la génération-recombinaison des porteurs dans la ZCE (Zone de Charge d'Espace). En effet, une grande partie de la ZCE (sur les bords de la photodiode) est comprise dans un matériau plus grand gap. Cette diminution locale de la génération-recombinaison va entrainer une baisse du courant d'obscurité de la photodiode.

La matrice de photodiodes 400 présente alors un courant d'obscurité réduit, en comparaison avec une matrice de photodiodes selon l'art antérieur. En particulier, pour une même technique de réalisation d'une jonction PN, on obtient une photodiode présentant un courant d'obscurité réduit, par exemple diminué de moitié.

Ces observations peuvent s'expliquer de la façon suivante :

Une photodiode ne permet de détecter que des longueurs d'onde dont l'énergie correspond sensiblement au gap du matériau de la deuxième zone dopée 252.

Comme précisé en référence à la figure 3, un matériau en $Cd_xHg_{1-x}Te$ présente un gap qui dépend de la concentration en cadmium. Une faible concentration en cadmium assure un faible gap et donc la détection d'un rayonnement de grande longueur d'onde, et inversement. En pratique, on cherche préférentiellement à détecter un rayonnement infrarouge, ce qui correspond à un faible gap du matériau de la deuxième zone dopée 252.

Un inconvénient d'un matériau à faible gap est cependant qu'il présente une sensibilité accrue aux défauts de la photodiode. En effet, plus le gap est petit, plus il est probable que des défauts du matériau introduisant un niveau d'énergie intermédiaire dans le matériau favorisent un franchissement spontané du gap par un électron. Il se forme ainsi spontanément des paires électron-trou dans le matériau. Une paire électron-trou correspond à l'apparition dans la couche utile d'un porteur minoritaire (l'électron ou le trou). Lorsque le porteur minoritaire traverse une jonction PN, on mesure un courant électrique qui ne correspond pas à l'absorption d'un rayonnement électromagnétique. On parle pour cette raison de courant d'obscurité. Le courant d'obscurité va ainsi être une limite à la détection de très faibles rayonnements dans l'infrarouge.

Les défauts dans la couche utile sont plus nombreux en surface, à proximité de la face supérieure 208. Cela s'explique par le fait que la qualité cristalline d'une interface ne peut être aussi élevée que la qualité cristalline au centre de la couche utile. En outre, la face supérieure 208 est la face exposée à l'environnement, en particulier aux différents traitements subis par la couche utile 20, susceptibles d'introduire des impuretés. Ces traitements correspondent notamment aux étapes de réalisation de jonctions PN. Par exemple, dans le cas précédemment cité de la réalisation d'une jonction PN par implantation ionique d'arsenic.

Les défauts dans la couche utile sont ainsi plus nombreux à proximité à la fois de la face supérieure 208 et des jonctions PN, notamment lorsque les jonctions PN sont réalisées par implantation d'arsenic.

Les régions 24 de la matrice de photodiodes 400 selon l'invention présentent chacune un gradient de cadmium, qui correspond donc à un gradient de gap nommé ouverture de gap.

La matrice de photodiodes présente :

- un gap élevé en surface et entre les jonctions PN, ce qui diminue la sensibilité de la couche utile aux défauts présents en surface et entre les jonctions PN,
- un gap élevé en surface et au niveau des jonctions PN, dans des volumes périphériques supérieurs 255 des premières zones dopées 251, ce qui diminue la sensibilité de la couche utile aux défauts provenant d'une implantation ionique, et
- un gap qui reste réduit en profondeur, dans une région dite d'absorption, ce qui permet de détecter un rayonnement électromagnétique à la longueur d'onde souhaitée.

Par ailleurs les premières zones dopées 251 ne sont pas enfermées à l'intérieur d'une région 24, permettant de ne pas limiter le rendement quantique. Ces premières zones dopées 251 s'étendent dans la couche utile plus profondément que les régions 24, ce qui améliore encore le rendement quantique.

Chaque ouverture de gap forme également une barrière de potentiel qui empêche des porteurs minoritaires formés en profondeur dans la couche utile de venir se recombiner sur les défauts de surface, sans traverser une jonction PN et donc sans former un courant.

On relève qu'il n'est pas gênant que le gradient de concentration en cadmium ne soit pas présent dans un volume central des premières zones dopées 251. En effet, la densité de dopage dans ces premières zones dopées est généralement suffisamment élevée pour limiter l'impact des défauts présents.

Avantageusement, les régions 24 ne recouvrent les premières zones dopées 251 que sur un volume réduit, et donc ne recouvrent les jonctions PN que sur une surface réduite de chacune d'elles. Par exemple, les régions 24 recouvrent moins de 20% de la surface totale de chaque jonction PN. On maximise ainsi le rendement quantique, en limitant les portions de jonction PN auxquelles les porteurs minoritaires n'auront pas accès du fait de la barrière de potentiel associée à une région 24.

De préférence, les régions 24 sont présentes avant même toute étape de réalisation d'une jonction PN. Ainsi, lors de la réalisation d'une jonction PN, la couche utile est protégée sur une majeure partie de sa face supérieure 208 grâce aux gradients de cadmium. En d'autres termes, la couche utile est rendue moins sensible à toute contamination par l'environnement. Par ailleurs lors de la réalisation d'une jonction PN, les défauts liés à l'implantation ioniques seront localisés dans un matériau plus grand gap.

On voit donc que l'invention est particulièrement avantageuse pour la détection de grandes longueurs d'onde, dans l'infrarouge lointain (LWIR), voir très lointain (VLWIR, pour l'anglais « Very Long Wave InfraRed », correspondant à des longueurs d'onde supérieures à 8 μm à 80 K). En effet, pour la détection de ces longueurs d'onde, on doit réaliser une faible concentration en cadmium dans la deuxième zone dopée 252 (x<0,3, par exemple x=0,22) ce qui correspond à une grande sensibilité des photodiodes aux défauts de la couche utile, dans des matrices de photodiodes selon l'art antérieur.

Selon une variante non représentée, les régions 24 à grande concentration en cadmium s'étendent plus profondément dans la couche utile que les premières zones dopées 251. Les régions peuvent s'étendre sur une partie de l'épaisseur de la couche utile ou traverser la couche utile sur toute son épaisseur. Comme expliqué à propos des figures 1 et 3, on obtient une matrice de photodiodes présentant une FTM optimale (les régions 24 séparent complètement les pixels de la matrice). On obtient en outre un courant d'obscurité réduit du fait de la présence des bords de caisson 251 dans des régions 24.

On remarque, au vu des explications ci-dessus, que dans le mode de réalisation de la matrice de photodiode tel qu'illustré en figure 3, les régions 14 stabilisent une partie de la surface de la couche utile ce qui peut diminuer le courant d'obscurité.

On a représenté en figure 5 un troisième mode de réalisation d'une matrice de photodiodes 500 selon l'invention.

La figure 5 ne sera décrite que pour ses différences relativement à la figure 4. Les références numériques 20, 21, 24, 222, 251, 252, 255 de la figure 4 correspondent respectivement aux références numériques 50, 51, 54, 522, 551, 552, 555 de la figure 5.

La matrice de photodiodes 500 a été réalisée à l'aide d'un procédé selon l'invention mettant en oeuvre :

-   les étapes 100 à 102 telles que décrites en référence à la figure 1, de façon à ce que chaque région 54 présente une première portion 560 présentant un gradient de concentration en cadmium tel que décrit en référence aux figures 1 et 3, qui s'étend profondément dans la couche utile et à l'extérieur des premières zones dopées 551 ;
-   une étape de suppression de la couche correspondant, après recuit, à la couche structurée formée à l'étape 101; puis
-   les étapes 200 à 202 telles que décrites en référence à la figure 2, de façon à ce que chaque région 54 présente une seconde portion 561 présentant un gradient de concentration en cadmium tel que décrit en référence aux figures 2 et 4, qui s'étend peu profondément dans la couche utile et qui recouvre partiellement des premières zones dopées 551.

Une étape de réalisation d'une jonction PN est mise en oeuvre, par exemple avant l'étape 100, ou après l'étape 202, ou entre les étapes 102 et 200.

Ainsi, la matrice de photodiodes 500 combine les avantages cités à propos de la matrice de photodiodes 300 illustrée en figure 3 et de la matrice de photodiodes 400 illustrée en figure 4.

On pourra imaginer toutes sortes de variantes, mettant en oeuvre un ou plusieurs cycles comprenant les étapes telles que décrites en référence aux figures 1 ou 2, de réalisation d'une couche structurée riche en cadmium et recuit. Entre deux cycles, on supprime avantageusement la couche correspondant, après recuit, à la couche structurée précédemment formée. Chacun des cycles peut mettre en oeuvre une couche structurée de forme différente.

L'invention n'est pas limitée aux exemples qui viennent d'être cités, et on pourra envisager toutes sortes de variantes, notamment différentes formes de régions présentant un gradient de cadmium. Ces formes pourront être obtenues à l'aide de procédés selon l'invention, par une couche structurée adaptée et le recours éventuel à plusieurs cycles tels que décrits ci-dessus.

Par ailleurs ces régions peuvent être traversantes sur toute l'épaisseur de la couche utile.

## Revendications

1.   Matrice de photodiodes (500) comprenant :

- une couche dite utile (50) en un alliage semi-conducteur de cadmium, mercure et tellure de type $Cd_xHg_{1-x}Te$, la couche utile présentant une face supérieure et une face inférieure ;
- au moins deux premières zones dopées (551), situées dans la couche utile, formant chacune une jonction PN avec une deuxième zone dopée (552) entourant les premières zones dopées, les jonctions PN affleurant la face supérieure de la couche utile ;

la matrice (500) comprenant au moins une région (54), située entre deux jonctions PN voisines, et présentant un gradient de concentration en cadmium décroissant depuis la face supérieure vers la face inférieure de la couche utile ; ladite au moins une région (54) présentant:

- une première portion (560) s'étendant à l'extérieur des premières zones dopées (551) ; et
- une seconde portion (561) recouvrant partiellement les premières zones dopées (551) la première portion (560) s'étendant plus profondément dans la couche utile (50) que la seconde portion (561), la première portion (560) étant entourée par la seconde portion (561), et la première portion (560) s'étendant dans la couche utile plus profondément que les premières zones dopées;

**caractérisée en ce que**
la matrice de photodiodes est une matrice de photodiodes planaires; et
la seconde portion (561) s'étend dans un volume périphérique supérieur (555) d'au moins une première zone dopée (551).

2. Matrice (500) selon la revendication 1, **caractérisée en ce que** ladite région (54) s'étend dans une première zone dopée (551) sur moins de la moitié du volume de celle-ci.

3. Matrice de photodiodes (300) comprenant :

- une couche dite utile (10) en un alliage semi-conducteur de cadmium, mercure et tellure de type $Cd_xHg_{1-x}Te$, la couche utile présentant une face supérieure et une face inférieure ;
- au moins deux premières zones dopées (151), situées dans la couche utile, formant chacune une jonction PN avec une deuxième zone dopée (152) entourant les premières zones dopées, les jonctions PN affleurant la face supérieure de la couche utile ;

la matrice (300) comprenant au moins une région (14), située entre deux jonctions PN voisines, et présentant un gradient de concentration en cadmium décroissant depuis la face supérieure (108) vers la face inférieure (109) de la couche utile;
ladite au moins une région (14) s'étendant dans la couche utile (10) plus profondément que les premières zones dopées (151);
**caractérisée en ce que** ladite au moins une région (14) s'étend entre deux jonctions PN (15) à l'extérieur de chaque première zone dopée (151), et
la matrice de photodiodes est une matrice de photodiodes planaires.

4. Matrice (300 ; 500) selon la revendication 1, 2 ou 3, **caractérisée en ce que** la concentration moyenne en cadmium dans ladite région (14 ; 54) est supérieure à la concentration moyenne en cadmium dans le reste de la couche utile (10 ; 50).

5. Matrice (300 ; 500) selon l'une quelconque des revendications 1 à 4, **caractérisée en ce que** la première zone dopée (151 ; 551) est dopée P par des atomes d'arsenic.

6. Procédé de fabrication d'une matrice de photodiodes (300 ; 500) selon l'une quelconque des revendications 1 à 5, **caractérisé en ce qu'**il comprend les étapes suivantes :

- réalisation (100, 101 ; 200, 201), sur la face supérieure (108 ; 208) de la couche utile (10; 50), d'une couche dite structurée (122, 522) présentant au moins une ouverture traversante, et ayant une concentration en cadmium supérieure à la concentration en cadmium de la couche utile ;
- recuit (102 ; 202) de la couche utile recouverte de la couche structurée, réalisant une diffusion des atomes de cadmium de la couche structurée, depuis la couche structurée vers la couche utile;
- réalisation (103 ; 203) d'au moins deux jonctions PN dans la couche utile.

7. Procédé selon la revendication 6, **caractérisé en ce que** la réalisation (100, 101 ; 200, 201) d'une couche structurée met en oeuvre :

- un dépôt (100 ; 200) d'une couche de réservoir (12 ; 22) sur la face supérieure (108 ; 208) de la couche utile; et
- une gravure (101 ; 201) d'au moins une ouverture traversante dans la couche de réservoir, la gravure étant une gravure chimique.

8. Procédé selon la revendication 6 ou 7, **caractérisé en ce que** les étapes de réalisation (100, 101; 200, 201) d'une couche structurée et recuit forment un cycle de fabrication, et **en ce que** l'on met en oeuvre au moins deux cycles de fabrication.

9. Procédé selon l'une quelconque des revendications 6 à 8, **caractérisé en ce que** l'étape de réalisation de jonctions PN met en oeuvre une implantation ionique d'arsenic.

10. Procédé selon l'une quelconque des revendications 6 à 9, **caractérisé en ce que** le recuit est réalisé à une température comprise entre 100°C et 500°C.

11. Procédé selon la revendication 10, **caractérisé en ce que** le recuit (103 ; 203) est réalisé pendant une durée comprise entre 1h et 100h.

**Patentansprüche**

1. Matrix aus Photodioden (500), enthaltend:

- eine sogenannte Nutzschicht (50) aus einer Halbleiterlegierung aus Cadmium, Quecksilber und Tellur vom Typ $Cd_xHg_{1-x}Te$, wobei die Nutzschicht eine Oberseite und eine Unterseite aufweist;
- zumindest zwei erste dotierte Zonen (551), die sich in der Nutzschicht befinden und jeweils mit einer zweiten dotierten Zone (552) einen p-n-Übergang bilden, wobei die zweite dotierte Zone die ersten dotierten Zonen umgibt, und wobei die p-n-Übergänge mit der Oberseite der Nutzschicht bündig sind;

wobei die Matrix (500) zumindest einen Bereich (54) aufweist, der sich zwischen zwei benachbarten p-n-Übergängen befindet und einen Cadmiumkonzentrationsgradienten aufweist, der von der Oberseite zur Unterseite der Nutzschicht abnimmt; wobei der zumindest eine Bereich (54) aufweist:

- einen ersten Abschnitt (560), der sich außerhalb der ersten dotierten Zonen (551) erstreckt; und
- einen zweiten Abschnitt (561), der die ersten dotierten Zonen (551) teilweise bedeckt;

wobei der erste Abschnitt (560) sich tiefer in der Nutzschicht (50) erstreckt als der zweite Abschnitt (561), wobei der erste Abschnitt (560) von dem zweiten Abschnitt (561) umgeben ist und der erste Abschnitt (560) sich tiefer in der Nutzschicht erstreckt als die ersten dotierten Zonen; **dadurch gekennzeichnet, dass** die Matrix aus Photodioden eine Matrix aus planaren Photodioden ist; und der zweite Abschnitt (561) sich in einem oberen Umfangsvolumen (555) von zumindest einer ersten dotierten Zone (551) erstreckt.

2. Matrix (500) nach Anspruch 1, **dadurch gekennzeichnet, dass** der Bereich (54) sich in einer ersten dotierten Zone (551) zumindest über die Hälfte des Volumens derselben erstreckt.

3. Matrix aus Photodioden (300), enthaltend:

- eine sogenannte Nutzschicht (10) aus einer Halbleiterlegierung aus Cadmium, Quecksilber und Tellur vom Typ $Cd_xHg_{1-x}Te$, wobei die Nutzschicht eine Oberseite und eine Unterseite aufweist;
- zumindest zwei erste dotierte Zonen (151), die sich in der Nutzschicht befinden und jeweils mit einer zweiten dotierten Zone (152) einen p-n-Übergang bilden, wobei die zweite dotierte Zone die ersten dotierten Zonen umgibt, und wobei die p-n-Übergänge mit der Oberseite der Nutzschicht bündig sind;

wobei die Matrix (300) zumindest einen Bereich (14) aufweist, der sich zwischen zwei benachbarten p-n-Übergängen befindet und einen Cadmiumkonzentrationsgradienten aufweist, der von der Oberseite (108) zur Unterseite (109) der Nutzschicht abnimmt; wobei der zumindest eine Bereich (14) sich tiefer in der Nutzschicht (10) erstreckt als die ersten dotierten Zonen (151); **dadurch gekennzeichnet, dass** der zumindest eine Bereich (14) sich zwischen zwei p-n-Übergängen (15) außerhalb von jeder ersten dotierten Zone (151) erstreckt und die Matrix aus Photodioden eine Matrix aus planaren Photodioden ist.

4. Matrix (300; 500) nach Anspruch 1, 2 oder 3, **dadurch gekennzeichnet, dass** die mittlere Cadmiumkonzentration in dem Bereich (14; 54) höher als die mittlere Cadmiumkonzentration in der restlichen Nutzschicht (10; 50) ist.

5. Matrix (300; 500) nach einem der Ansprüche 1 bis 4, **dadurch gekennzeichnet, dass** die erste dotierte Zone (151; 551) mit Arsenatomen p-dotiert ist.

6. Verfahren zum Herstellen einer Matrix aus Photodioden (300; 500) nach einem der Ansprüche 1 bis 5, **dadurch gekennzeichnet, dass** es die nachfolgenden Schritte umfasst:

- Ausbilden (100, 101; 200, 201) einer sogenannten strukturierten Schicht (122, 522) auf der Oberseite (108; 208) der Nutzschicht (10; 50), die zumindest eine durchgehende Öffnung aufweist und eine Cadmiumkonzentration hat, die höher als die Cadmiumkonzentration der Nutzschicht ist;
- Glühen (102; 202) der mit der strukturierten Schicht bedeckten Nutzschicht, wodurch eine Diffusion der Cadmiumatome der strukturierten Schicht aus der strukturierten Schicht zur Nutzschicht erfolgt;
- Ausbilden (103; 203) von zumindest zwei p-n-Übergängen in der Nutzschicht.

7. Verfahren nach Anspruch 6, **dadurch gekennzeichnet, dass** das Ausbilden (100, 101; 200, 201) einer strukturierten Schicht umfasst:

- Abscheiden (100; 200) einer Reservoirschicht (12; 22) auf die Oberseite (108; 208) der Nutzschicht; und
- Ätzen (101; 201) zumindest einer durchgehenden Öffnung in die Reservoirschicht, wobei das Ätzen ein chemisches Ätzen ist.

8. Verfahren nach Anspruch 6 oder 7, **dadurch gekennzeichnet, dass** die Schritte des Ausbildens (100, 101; 200, 201) einer strukturierten Schicht und des Glühens einen Herstellungszyklus bilden, und dass zumindest zwei Herstellungszyklen erfolgen.

9. Verfahren nach einem der Ansprüche 6 bis 8, **dadurch gekennzeichnet, dass** der Schritt des Ausbildens von p-n-Übergängen eine Ionenimplantation von Arsen umfasst.

10. Verfahren nach einem der Ansprüche 6 bis 9, **dadurch gekennzeichnet, dass** das Glühen bei einer Temperatur zwischen 100 °C und 500 °C erfolgt.

**11.** Verfahren nach Anspruch 10, **dadurch gekennzeichnet, dass** das Glühen (103; 203) für eine Zeitdauer zwischen 1 h und 100 h erfolgt.

**Claims**

**1.** Photodiodes array (500) comprising:

- a so-called useful layer (50) made of a semiconducting alloy of cadmium, mercury and tellurium of the $Cd_xHg_{1-x}Te$ type, the useful layer having an upper face and a lower face;
- at least two first doped zones (551), located in the useful layer, each forming a PN junction with a second doped zone (552) surrounding the first doped zones, the PN junctions being flush with the upper face of the useful layer;

wherein the array (500) comprises at least one region (54), located between two neighbouring PN junctions and having a cadmium concentration gradient decreasing from the upper face to the lower face of the useful layer;
wherein said at least one region (54) exhibits:

- a first portion (560) extending outside the first doped zones (551); and
- a second portion (561) partially covering the first doped zones (551);

wherein the first portion (560) extends deeper in the useful layer (50) than the second portion (561), the first portion (560) is surrounded by the second portion (561), and the first portion (561) extents deeper in the useful layer (50) than the first doped zones;
**characterised in that**
the photodiodes array is a matrix of planar photodiodes; and
the second portion (561) extends in an upper peripheral volume (555) of at least one first doped zone (551).

**2.** Array (500) according to claim 1, **characterised in that** said region (54) extends in a first doped zone (551) over less than half of the volume of this first doped zone.

**3.** Photodiodes array (300) comprising:

- a so-called useful layer (10) made of a semiconducting alloy of cadmium, mercury and tellurium of the $Cd_xHg_{1-x}Te$ type, the useful layer having an upper face and a lower face;
- at least two first doped zones (151), located in the useful layer, each forming a PN junction with a second doped zone (152) surrounding the first doped zones, the PN junctions being flush with the upper face of the useful layer;

wherein the array (300) comprises at least one region (14), located between two neighbouring PN junctions and having a cadmium concentration gradient decreasing from the upper face (108) to the lower face (109) of the useful layer;
wherein said at least one region (14)) extents deeper in the useful layer (10) than the first doped zones (151);
**characterised in that** said at least one region (14)) extents between two PN junctions (15) outside each first doped zone (151), and the photodiodes array is a matrix of planar photodiodes.

**4.** Array (300; 500) according to claim 1, 2 or 3, **characterised in that** the average concentration of cadmium in said region (14; 54) is higher than the average cadmium concentration in the remainder of the useful layer (10; 50).

**5.** Array (300; 500) according to any one of claims 1 to 4, **characterised in that** the first doped zone (151; 551) is P-doped by arsenic atoms.

**6.** Method of fabrication of a photodiodes array (300; 500) according to any one of claims 1 to 5, **characterised in that** it comprises the following steps:

- production (100; 101; 200; 201), on the upper face (108; 208) of the useful layer (10; 50), of a so-called structured layer (121; 522) with at least one through opening, and with a cadmium concentration higher than the cadmium concentration in the useful layer;
- annealing (102; 202) of the useful layer covered by the structured layer, with diffusion of cadmium atoms of the structured layer, from the structured layer to the useful layer;
- production (103; 203) of at least two PN junctions in the useful layer.

**7.** Method according to claim 6, **characterised in that** the production (100. 101; 200. 201) of a structured layer involves:

- a deposit (100; 200) of a reservoir layer (12; 22) on the upper face (108; 208) of the useful layer; and
- etching (101; 201) of at least one through opening in the reservoir layer, the etching being a chemical etching.

**8.** Method according to claim 6 or 7, **characterised in that** the steps (100; 101; 200; 201) of production of a structured layer and annealing form a fabrication cycle, and at least two fabrication cycles are implemented.

9. Method according to any one of claims 6 to 8, **characterised in that** the step of production of the PN junctions make use of an arsenic ion implantation.

10. Method according to any one of claims 6 to 9, **characterised in that** annealing is done at a temperature of between 100°C and 500°C.

11. Method according to claim 10, **characterised in that** annealing (103; 203) is done for a duration of between 1 hour and 100 hours.

FIG.1

EP 2 937 902 B1

FIG.2

15

FIG.3

FIG.4

FIG.5

**RÉFÉRENCES CITÉES DANS LA DESCRIPTION**

**Documents brevets cités dans la description**

- US 5880510 A
- US 4588446 A
- EP 0445545 A
- US 4961098 A
- FR 2983351
- JP 62119976 A